# EUROPÄISCHE PATENTANMELDUNG

(11) **EP 3 929 595 A1**
(43) Veröffentlichungstag der Anmeldung: **29.12.2021**
(21) Anmeldenummer: 21177765.1
(22) Anmeldetag: 04.06.2021
(51) Int. Cl.: G01R 15/00, G01R 15/08, G01R 15/09, G01R 22/06

(54) **ENERGIEMESSKLEMME BEZIEHUNGSWEISE MESSSCHALTUNG EINER ENERGIEMESSKLEMME**

(30) Priorität: 08.06.2020 DE 102020115180
(71) Anmelder: Turck Holding GmbH, 58553 Halver (DE)
(72) Erfinder: Wohlrab, Jürgen Daniel, 09419 Thum (DE); Weigel, Wolfgang Dieter, 09350 Lichtenstein (DE); Hartisch, Thomas, 08344 Grünhain-Beierfeld (DE)
(74) Vertreter: Grundmann, Dirk

(57) **Zusammenfassung**

Die Erfindung betrifft eine Messschaltung zur Ermittlung der Größe eines durch einen Leiter (9, 9') fließenden Stroms, mit einem Eingangsklemmenpaar (11, 11', 23), das an einen Stromwandler (8) anschließbar ist, mit einem ersten Schalter (13), der in einer Strommessstellung einen Messwiderstand (16, 17) zwischen die Eingangsklemmen (11, 11') schaltet und der in einer Spannungsmessstellung den Messwiderstand (16, 17) von zumindest einer der Eingangsklemmen (11, 11') trennt, und mit einem Ausgangsklemmenpaar (37, 37'), an dem wahlweise eine an dem Eingangsklemmenpaar (11, 11') anliegende spannungsabhängige Messspannung oder eine an einem ersten Messpunkt (38) des Messwiderstandes (16, 17) anliegende stromabhängige Messspannung abgreifbar ist. Erfindungsgemäß ist ein Umschalter (19) vorgesehen, der mit dem Schalter (13, 14, 15) synchron geschaltet werden kann. Mit dem Umschalter (19) wird eine Ausgangsklemme (37) in der Strommessstellung mit dem ersten Messpunkt (38) und in der Spannungsmessstellung mit dem zweiten Messpunkt (39) verbunden.

## Beschreibung

### Gebiet der Technik

Die Erfindung betrifft eine an einen Stromwandler anschließbare Messschaltung zur Ermittlung der Größe eines durch einen Leiter fließenden Stroms, mit einem Eingangsklemmenpaar, das an den Stromwandler anschließbar ist, mit einem ersten Schalter, der in einer Strommessstellung einen Messwiderstand zwischen die Eingangsklemmen schaltet und der in einer Spannungsmessstellung den Messwiderstand von zumindest einer der Eingangsklemmen trennt, und mit einem Ausgangsklemmenpaar, an dem wahlweise eine an dem Eingangsklemmenpaar anliegende spannungsabhängige Messspannung oder eine an einem ersten Messpunkt des Messwiderstandes anliegende stromabhängige Messspannung abgreifbar ist.

Die Erfindung betrifft darüber hinaus eine Energiemessklemme aufweisend eine derartige Messschaltung.

### Stand der Technik

Die EP 3 392 664 B1 beschreibt eine Messschaltung, bei der zwei Ausgangsklemmen eines Stromwandlers, an denen entweder eine Spannung anliegt oder von denen ein Strom bereitgestellt wird. Die Messschaltung kann an eine Leistungsmesseinrichtung angeschlossen werden, die mit einem Spannungswandler die an einer Stromversorgungsleitung anliegende Spannung misst, und die mit der Messschaltung den durch die Stromversorgungsleitung fließenden Strom misst. Wird in eine stromführende Leitung als Stromwandler ein Transformator geschaltet, so wird ein dem durch die stromführende Leitung fließenden Strom proportionaler Strom erzeugt, der von der Messschaltung in eine Spannung gewandelt wird, die dem Strom proportional ist. Hierzu wird mittels eines Schalters ein Messwiderstand zwischen die Ausgangsklemmen des Stromwandlers geschaltet. Die am Messwiderstand abfallende Spannung ist ein Maß für den Strom und wird von einer Spannungsmesseinrichtung gemessen. Wird um eine stromführende Leitung als Stromwandler aber beispielsweise eine Rogowski-Spule gelegt, so liefert dieser Stromwandler eine zum durch die stromführende Leitung fließenden Strom proportionale Spannung. Um diese Spannung zu messen, wird der Schalter geöffnet, sodass die Spannung unmittelbar von der Spannungsmesseinrichtung gemessen werden kann.

Zum Stand der Technik gehören ferner die EP 3 393 042 A1,
DE 18 12 255 A1, WO 2014/058728 A1, WO 99/57578 A1 und DE 25 27 392 A1.

### Zusammenfassung der Erfindung

Der Erfindung liegt die Aufgabe zugrunde, die gattungsgemäße Messschaltung beziehungsweise eine gattungsgemäße Energiemessklemme gebrauchsvorteilhaft weiterzubilden. Der Erfindung liegt insbesondere die Aufgabe zugrunde, eine konfigurierbare Messschaltung anzugeben, die sowohl Ausgangsströme als auch Ausgangsspannungen als Eingangssignale verwenden kann. Der Erfindung liegt insbesondere weiter die Aufgabe zugrunde, eine Messschaltung anzugeben, die ohne zusätzliche Leistungszufuhr aus dem zu messenden Netz arbeitet. Der Erfindung liegt weiter insbesondere die Aufgabe zugrunde, eine gattungsgemäße Messschaltung mit einem geringen Schaltungsaufwand anzugeben. Insbesondere liegt der Erfindung die Aufgabe zugrunde, die Genauigkeit der Messschaltung zu vergrößern.

Gelöst wird die Aufgabe durch die in den Ansprüchen angegebene Erfindung, wobei die Unteransprüche nicht nur vorteilhafte Weiterbildungen der in den nebengeordneten Ansprüchen angegebenen Erfindung, sondern auch eigenständige Lösungen der Aufgabe darstellen.

Während beim gattungsbildenden Stand der Technik zur Strommessung die an dem mit dem Messwiderstand in Reihe geschalteten Schalter und dem Messwiderstand abfallende Spannung gemessen wird, wird erfindungsgemäß vorgeschlagen, dass der Schalter so angeordnet ist, dass die beiden Eingangsklemmen eine Spannungsmesseinrichtung über einen Umschalter unmittelbar mit dem Messwiderstand elektrisch leitverbindbar sind. Die Eingangsklemmen der Spannungsmesseinrichtung sind dabei entweder direkt oder über einen Filter mit den Ausgangsklemmen der Messschaltung verbunden. Mit dem Filter können hochfrequente Störsignale ausgefiltert werden. Der zwischen Spannungsmesseinrichtung und dem Messwiderstand liegende Filter ist bevorzugt ein ein- oder mehrstufiger Tiefpassfilter. Der Umschalter kann mit dem Schalter gekoppelt sein, der den Messwiderstand in eine Stromfließverbindung mit den Ausgangsklemmen des Stromwandlers verbindet. Der Umschalter kann mit dem Schalter synchronisiert sein. Der Umschalter kann eine Eingangsklemme der Spannungsmesseinrichtung oder des ihr vorgeordneten Filters wahlweise mit einem Knoten zwischen Schalter und Messwiderstand oder mit der Ausgangsklemme des Stromwandlers, die bevorzugt mit einer Klemme des Schalters verbunden ist, verbinden. Ist der Schalter sperrend, sodass kein Strom durch den Messwiderstand fließt, liegt die vom Stromwandler gelieferte Spannung an einem Kontakt des Umschalters an, der in eine Leitverbindung mit der in eine Leitverbindung mit der Ausgangsklemme der Messschaltung beziehungsweise der Eingangsklemme der Spannungsmesseinrichtung gebracht wird. Ist hingegen der Schalter leitend, so fließt ein Strom durch den Schalter und den Messwiderstand. Die beiden Klemmen des Messwiderstandes sind über den dann umgeschalteten Umschalter mit der Spannungsmesseinrichtung leitungsverbunden, sodass die am Messwiderstand abfallende Spannung gemessen werden kann. Der Umschalter kann eine Ausgangsklemme der Messschaltung wahlweise mit einem Messpunkt des Messwiderstandes zur Strommessung oder mit einem Messpunkt zur Spannungsmessung verbinden, wobei der zuletzt genannte Messpunkt auf dem Potenzial der Eingangsklemme liegt. In einer Weiterbildung der Erfindung ist vorgesehen, dass zu der aus dem ersten Schalter und dem ersten Messwiderstand bestehenden Schaltungsgruppe eine identische Schaltungsgruppe parallel geschaltet ist, die aus einem zweiten Schalter und einem zweiten Messwiderstand besteht, wobei sich die beiden Schaltungsgruppen im Wesentlichen nur durch den Widerstandswert des jeweiligen Messwiderstandes unterscheiden, sodass mit einer derartigen Schaltungsanordnung zwei Messbereiche abgedeckt werden können. Mit weiteren derartigen Schaltungsgruppen können weitere Messbereiche abgedeckt werden. Jede dieser Schaltungsgruppen weist einen Anschlussknoten zwischen Messwiderstand und Schalter auf, der einen Messpunkt ausbildet, der mit dem Umschalter wahlweise in eine Leitverbindung mit der Eingangsklemme der Spannungsmesseinrichtung beziehungsweise der Ausgangsklemme der Messschaltung gebracht werden kann. Der erste beziehungsweise zweite Schalter ist somit mit einer ersten Klemme mit der Ausgangsklemme des Stromwandlers und mit einer zweiten Klemme mit dem Anschlussknoten verbunden. Beim Betrieb der Messschaltung werden die beiden ersten und zweiten Schalter zeitgleich mit dem Umschalter geschaltet. In einer Weiterbildung der Erfindung wird ein dritter Schalter vorgeschlagen. Dieser dritte Schalter kann den Umschalter mit der Ausgangsklemme des Stromwandlers verbinden. In einer bevorzugten Ausgestaltung verbindet der dritte Schalter die beiden Ausgangsklemmen des Stromwandlers beziehungsweise die Eingangsklemmen der Messschaltung mit einem Kondensator. Der Kondensator hat eine derart geringe Kapazität, dass er nur hohe Wechselströme kurzschließt und das Messergebnis der Messschaltung beim Messen von niederfrequenten Strömen von beispielsweise 50 Hz oder 60 Hz nicht beeinflusst. Der Umschalter besitzt einen gemeinsamen Kontakt, der mit einer Ausgangsklemme, mit dem Filter oder der Spannungsmesseinrichtung verbunden ist. Dieser gemeinsame Kontakt kann wahlweise mit Schaltkontakten elektrisch verbunden werden, wobei die Anzahl der elektrischen Schaltkontakte der Anzahl der Schalter entspricht, mit denen entweder ein Messwiderstand oder ein Kondensator mit den Ausgangsklemmen des Stromwandlers verbunden werden kann. In einer Weiterbildung der Erfindung, die auch eigenständigen Charakter aufweist, sind die Schalter oder ist zumindest einer der Schalter als elektrisch betätigbare Schalter ausgebildet. Der Umschalter kann ebenfalls ein elektrisch betätigbarer Schalter sein. Die Schalter und der Umschalter können Halbleiterschalter sein. Grundsätzlich können die Schalter und der Umschalter aber auch von elektromechanischen Bauteilen, beispielsweise Relais ausgebildet sein. Bevorzugt sind zumindest die Schalter als MOSFET ausgebildet. Die Messwiderstände sind bevorzugt derart niederohmig, dass der durch sie hindurchfließende Strom, der je nach Beschaltung bis zu 1 A oder bis zu 5 A betragen kann, an der Body-Diode des MOSFET eine Spannung abfallen lässt, die geringer ist, als die Flussspannung der Body-Diode, also beispielsweise geringer als 0,7 V. Es kann sich dabei einerseits um den MOSFET handeln, der mit dem Messwiderstand in Reihe geschaltet ist. Sind mehrere jeweils mit einem Messwiderstand in Reihe geschaltete MOSFETs parallel geschaltet, so sind bevorzugt alle Messwiderstände derart dimensioniert, dass in jedem Betriebszustand die an einem Kanalwiderstand eines der MOSFETs abfallende Spannung kleiner ist, als die Flussspannung der den Kanal abbildenden Body-Diode. Hierdurch ist es nicht erforderlich, zwei antiserielle N-Kanal MOSFET zu schalten, wie es beim oben genannten Stand der Technik der Fall ist. Durch die Reduzierung der am MOSFET beziehungsweise am Messwiderstand abfallenden Spannung reicht ein MOSFET aus, um auch Wechselströme zu messen. In einer Weiterbildung der Erfindung kann der oben genannte ein- oder mehrstufige Tiefpassfilter und/ oder eine Überspannungsschutzschaltung vorgesehen sein. Die Überspannungsschutzschaltung kappt im Wesentlichen Spannungsspitzen, die vom Stromwandler geliefert werden. Eine besonders wenig Bauteile aufweisende Schaltung besitzt lediglich einen Schalter und einen Umschalter, der einen gemeinsamen Kontakt mit zwei Schaltkontakten verbinden kann. Einer der beiden Schaltkontakte ist mit einem Knotenpunkt zwischen Schalter und Messwiderstand und der andere der beiden Schaltkontakte mit der Ausgangsklemme des Stromwandlers verbunden. Der letzte Schaltkontakt kann auch über einen Kondensator zusätzlich mit der anderen Ausgangsklemme des Stromwandlers verbunden sein. Auch hier werden Umschalter und Schalter synchron geschaltet. In einer Weiterbildung der Erfindung kann vorgesehen sein, dass zwei Messwiderstände in Reihe und diese beiden Messwiderstände wiederum in Reihe mit dem Schalter geschaltet sind. Das Strom- oder Spannungssignal des Stromwandlers kann wahlweise über den Schalter an die beiden Messwiderstände geschaltet werden oder durch Wahl der Eingangsklemmen der Messschaltung mit einer Verbindungsleitung zum Knoten zwischen den beiden Messwiderständen geschaltet werden. Über eine derartige Änderung der Beschaltung lassen sich verschiedene Messbereiche einstellen. Beispielsweise kann ein Messstrom, der bis zu 1 A betragen kann, über den leitenden Schalter durch beide Messwiderstände fließen oder kann ein Messstrom, der bis zu 5 A betragen kann, nur durch einen der beiden Messwiderstände hindurchfließen. Über den anderen Messwiderstand wird dann bei sperrendem Schalter die am durchströmten Messwiderstand abfallende Spannung gemessen.

Eine gemäß den zuvor beschriebenen Varianten ausgebildete Messschaltung wird in einer erfindungsgemäßen Energiemessklemme verwendet. Unter Energiemessklemme wird im Rahmen dieser Offenbarung jeder Apparat oder jede Apparatur bezeichnet, mit der ein durch einen Leiter fließender Strom beziehungsweise die durch den Leiter übertragene Leistung gemessen werden kann. Die Energiemessklemme besitzt eine Vielzahl von Anschlusskontakten, die in eine elektrische Leitverbindung mit einem Spannungswandler und einem Stromwandler gebracht werden können. Der Stromwandler liefert in der zuvor beschriebenen Weise eine Spannung, die zu einem Strom proportional ist, der durch eine stromführende Leitung, beispielsweise einer von drei Phasen einer Dreiphasenleitung, strömt. Diese oszilliert periodisch mit der Netzfrequenz. Mit dem Spannungswandler wird zwischen beispielsweise einem Nullleiter und einer der drei Phasen die Spannung gemessen. Auch diese oszilliert periodisch mit der Netzfrequenz. Die beiden oszillierenden Signale können phasenverschoben sein. Die Amplitude der Signale und die Phasenverschiebung werden mit einem Messumformer, der eine Spannungsmesseinrichtung aufweist, gemessen. Der Messumformer wandelt diese Signale in Angaben über eine aktuelle Leistung, insbesondere Scheinleistung und Wirkleistung, und in Phasenangaben um. Der Spannungswandler kann ein oder mehrere Spannungsteiler aufweisen, an denen der Messumformer eine zur Spannung zwischen der Phase und dem Nullleiter proportionale Spannung abgreift. Die Energiemessklemme kann darüber hinaus eine Steuerschaltung aufweisen. Mit dieser Steuerschaltung kann der Schalter beziehungsweise der Umschalter betätigt werden. Darüber hinaus erweist sich eine Kommunikationsschnittstelle als förderlich, mit der die vom Messumformer gewonnenen Werte als digitale Größen an Peripheriegeräte übertragen werden. Mit der erfindungsgemäßen Vorrichtung können Strom und Spannung in ein- und/oder mehrphasigen elektrischen Wechselstromnetzen gemessen werden. Aus den dabei gewonnenen Messwerten können elektrische Größen, wie Leistung, Energie, Phasenverschiebung und Leistungsfaktor, berechnet werden. Die Vorrichtung erlaubt die Analyse von elektrischen Netzwerken sowie Verbrauchern. Dabei werden die elektrischen Leiter zur Spannungsmessung direkt oder über einen Spannungswandler an der Vorrichtung angeschlossen. Die elektrischen Ströme der Phasen und gegebenenfalls auch des Nullleiters werden über Stromwandler galvanisch getrennt auf die Vorrichtung übertragen und dabei auf die für die Vorrichtung maximal zulässigen Strom- beziehungsweise Spannungswerte reduziert. Stromwandler können nach dem Transformatorprinzip arbeiten, welche am Ausgang als Stromquelle wirken. Die Stromwandler können aber auch nach dem Induktionsprinzip, beispielsweise als Rogowski-Spule arbeiten, die am Ausgang als Spannungsquelle wirken. Die Konfigurierung über die Schalter kann automatisch über die Steuerschaltung erfolgen, indem beispielsweise zunächst bei nicht leitenden Schaltern eine Spannung gemessen wird. Überschreitet diese einen oberen Grenzwert, so wird auf Strommessung umgeschaltet. Es ist aber auch möglich, zunächst die an einem der Widerstände abfallende Spannung zu messen, um bei Unterschreiten einer Grenzspannung auf Spannungsmessung umzuschalten. Mit der Überspannungsschutzschaltung wird gewährleistet, dass bei einem Strom liefernden Stromwandler keine zu hohe Spannung an der Spannungsmesseinrichtung anliegt. Die analoge Eingangsschaltung stellt somit eine Messspannung für eine vom Messumformer gebildete integrierte Energiemesseinheit zur Verfügung, welche die Messspannung differenziell erfasst, verstärkt und analog-digital-wandelt. Die digitalen Werte können von einem Mikroprozessor, der beispielsweise Teil der Steuerschaltung ist, weiterverarbeitet werden. Zusätzlich können weitere elektrische Größen berechnet werden. Die elektrischen Größen können lokal gespeichert und/ oder als Datenstrom an einen externen Speicher, zum Beispiel einen Netzwerkspeicher, Netzwerk-Speicher, (zum Beispiel Cloud) übertragen werden. Die erfindungsgemäße Weiterbildung liefert zumindest die folgenden Vorteile: Die konfigurierbare Eingangsbeschaltung erlaubt die Verwendung von Stromwandlern mit Ausgangsstrom- beziehungsweise Ausgangsspannungssignal mit einem Gerät. Aufgrund der konfigurierbaren Eingangsbeschaltung ist keine fehlerhafte Auswahl des Gerätes bezüglich der verwendeten Stromwandler möglich. Für die konfigurierbare Eingangsbeschaltung wird lediglich jeweils ein elektronischer Schalter benötigt. Zwei antiserielle elektronische Schalter, wie beim Stand der Technik, sind nicht erforderlich, was die Verlustleistung und die Beeinflussung der Messschaltung durch thermische Effekte reduziert. Eine analoge Filterschaltung kann je nach verwendeter Stromwandlerart konfiguriert werden und ist so dimensioniert, dass Temperatureinflüsse im Betriebstemperaturbereich keine bemerkenswerten Messabweichungen innerhalb der Messtoleranz hervorrufen. Durch Auswahl eines geeigneten MOSFET ist keine zusätzliche Pegelwandlung für die Ansteuerung der elektronischen Schalter erforderlich. Dies reduziert die Anzahl der Bauelemente und die Verlustleistung. Die Ausgangsspannung von unbeschalteten oder hochohmig beschaltet eine Spannung liefernden Stromwandlern wird auch begrenzt, wenn das Gerät nicht mit Energie versorgt wird, was die Zerstörung des Gerätes verhindert. Dies kann durch einen externen Leistungsversorger, beispielsweise eine Batterie oder einen Akkumulator erfolgen. Das Gerät kann aber auch über eine Netzspannung leistungsversorgt werden, wobei diese Spannung dann aber extern zugeführt wird und bevorzugt nicht aus der zu messenden Leistung gewonnen wird. Das Gerät wird unabhängig vom zu analysierenden Netz beziehungsweise der zu analysierenden Last mit Energie versorgt, was die elektrische Beeinflussung dieser verhindert. Die Mess- und Berechtigungsdaten können an einen Netzwerk-Speicher, beispielsweise eine Cloud übermittelt werden. Das nachträgliche Auswerten und langfristige Speichern zu Dokumentationszwecken ist möglich. Ferner ist eine Miniaturisierung möglich, da der erweiterte Funktionsumfang bevorzugt in einem Gerät untergebracht ist. Das Gerät kann Modulweise aufgebaut sein.

### Kurze Beschreibung der Zeichnungen

Ausführungsbeispiele der Erfindung werden nachfolgend anhand beigefügter Zeichnungen erläutert. Es zeigen:
- Fig. 1: ein Blockschaltbild einer mit einem Ein-Phasennetz verbundenen Energiemessklemme 10, wobei die Energiemessklemme 10 zusätzlich mit einem externen Speicher 36 beziehungsweise einer externen EDV-Einrichtung 35 verbunden ist,
- Fig. 2: ein Blockschaltbild der Energiemessklemme 10,
- Fig. 3: ein erstes Ausführungsbeispiel einer Strommessschaltung 1,
- Fig. 4: ein zweites Ausführungsbeispiel einer Strommessschaltung 1,
- Fig. 5: ein drittes Ausführungsbeispiel einer Strommessschaltung 1 und
- Fig. 6: ein Ausführungsbeispiel einer Spannungsmessschaltung 2.

### Beschreibung der Ausführungsformen

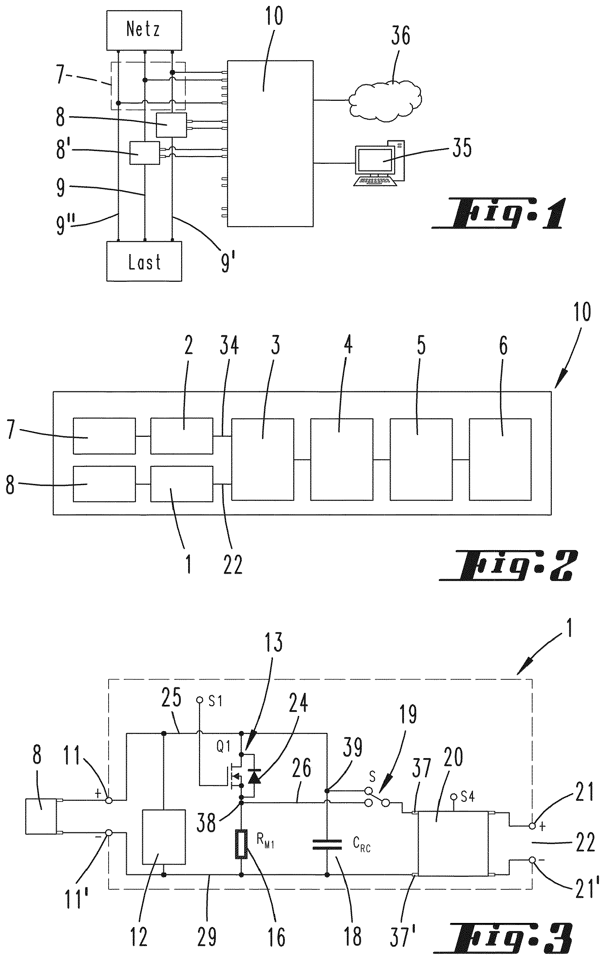

Die Figuren 1 und 2 zeigen grobschematisch eine Energiemessklemme 10, wie sie zur Messung von durch eine elektrische Versorgungsleitung hindurchfließende Leistung oder Energie verwendet wird. Die Figur 1 zeigt ein Ein-Phasennetz. In einer analogen Weise können aber auch an den zwei weiteren Phasen eines Drei-Phasennetzes an jeder der drei Phasen ein Strom und eine Spannung abgegriffen werden.

In den drei Phasen L1, L2, L3, von denen in der Figur 1 nur die Phase L1, 9 dargestellt ist, befinden sich jeweils Stromwandler 8, die ein zum durch die Phase L1, L2, L3 fließenden Strom proportionale Signale liefern. Diese Signale können Ströme oder Spannungen sein, je nachdem ob als Stromwandler 8 ein Transformator oder beispielsweise eine Rogowski-Spule verwendet wird. Die Figur 1 zeigt einen optionalen Stromwandler 8, der auch in den Nullleiter N, 9' eingeschleift ist.

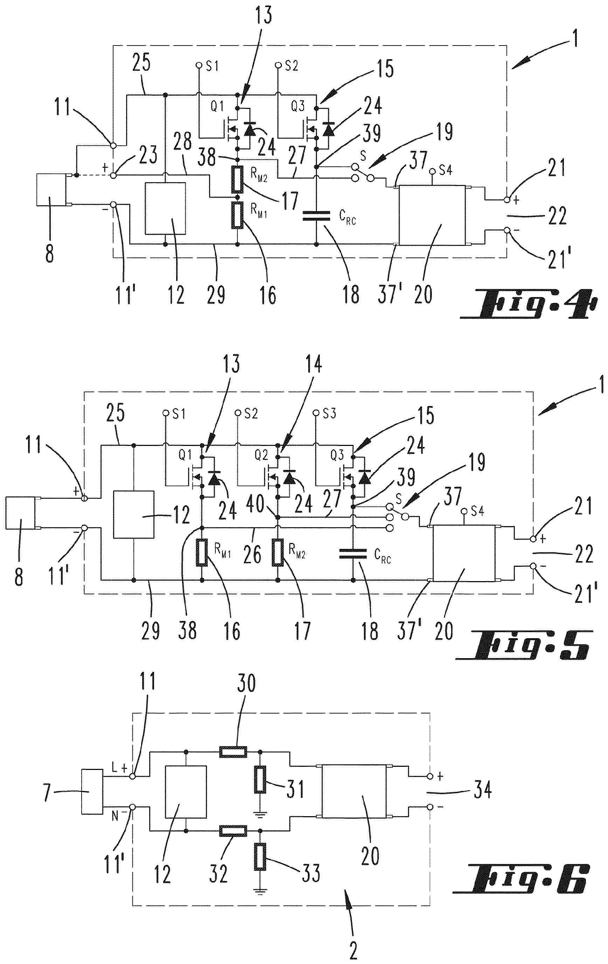

Durch direkten Anschluss oder unter Verwendung von Spannungswandlern 7 werden Spannungen zwischen Nullleiter 9' und Phase 9 gemessen. Mit der Bezugsziffer 2 ist eine Spannungsmessschaltung bezeichnet, die die direkt mit dem optionalen Spannungswandler 7 abgegriffene Spannung misst und in eine Messspannung umwandelt. Ein Ausführungsbeispiel zeigt die Figur 6.

Mit der Bezugsziffer 1 ist eine Strommessschaltung bezeichnet, die die vom Stromwandler 8 abgegebenen Signale in Messspannungen umwandelt. Ausführungsbeispiele zeigen die Figuren 3 bis 5.

Mit der Bezugsziffer 3 ist ein Messumformer, beispielsweise eine als integraler Schaltkreis handelsübliche Spannungsmesseinrichtung beziehungsweise Energiemesseinheit bezeichnet. Mit dieser Energiemesseinheit werden die von der Strommessschaltung 1 und der Spannungsmessschaltung 2 gewonnenen Messspannungen, bei denen es sich um Gleichspannungen handeln kann, bevorzugt aber um Wechselspannungen handelt, in Beziehung gesetzt. Dies erfolgt zur Ermittlung beispielsweise einer Wirkleistung, einer Scheinleistung oder eines Leistungsfaktors. Diese Daten werden als Digitaldaten einem Mikrokontroller, der von einer Steuereinrichtung 4 ausgebildet ist oder eine Steuereinrichtung 4 ausbildet, weiterverarbeitet. Über eine galvanische Trennung in Form einer Isolationseinrichtung 5 werden die gewonnenen Daten an eine Kommunikationsschnittstelle 6 geleitet, die die Daten an einen externen Datenspeicher 36 oder an eine externe EDV-Einrichtung 35 weiterleitet. Die Isolationseinrichtung 5 kann aber auch zwischen dem Messumformer 3 und dem Mikrokontroller 4 angeordnet sein.

Die Figur 3 zeigt ein erstes Ausführungsbeispiel einer erfindungsgemäßen Messschaltung. Ein Stromwandler 8 liefert, je nach Bauart, entweder ein zum durch einen der Leiter 9, 9' fließenden Strom proportionalen Strom oder eine dazu proportionale Spannung. Dieses Strom- oder Spannungssignal wird an den Ausgangsklemmen des Stromwandlers 8 abgegriffen. Die Ausgangsklemmen des Stromwandlers sind mit Eingangsklemmen 11, 11' der Messschaltung 1 verbunden. Zwischen den beiden Eingangsklemmen 11, 11' befindet sich eine Überspannungsschutzschaltung 12. Liefert der Stromwandler 8 eine Spannung, so sorgt die Überspannungsschutzschaltung 12 dafür, dass diese Spannung einen oberen Schwellwert nicht überschreitet, wenn die Sekundärseite der Eingangsklemmen 11,11' hochohmig ist. Die Überspannungsschutzschaltung 12 kann in der Art einer Zehnerdiode wirken. Die Überspannungsschutzschaltung 12, die ähnlich einer Zehnerdiode arbeitet, ist zwischen die Eingangsklemmen 11, 11' geschaltet.

Der Ausgang 22 der Messschaltung 1 ist mit Eingangsklemmen 21, 21' einer Spannungsmesseinrichtung 3 verbunden, die in der Figur 3 der Übersicht halber nicht dargestellt ist. Die eigentliche Messschaltung 1 besitzt Ausgangsklemmen 37, 37', die mit den Eingangsklemmen 21, 21' über einen Filter verbunden sind. Bei dem Filter handelt es sich um einen einstufigen, zweistufigen oder mehrstufigen Tiefpassfilter. Der Ausgang 37' kann unmittelbar mit der Eingangsklemme 11' verbunden sein.

Ein Messwiderstand 16, der niederohmig ist, kann mit einem von einem MOSFET gebildeten Schalter 13 in einen Kontakt mit den Eingangsklemmen 11, 11' gebracht werden, sodass der von den Eingangsklemmen 11, 11' gelieferte Strom durch den Schalter 13 und den Messwiderstand 16 fließt. Ein Messpunkt 38 wird von einem Knoten zwischen Messwiderstand 16 und Schalter 13 gebildet. Dort wird eine Spannung abgegriffen. Dies erfolgt mit der Verbindungsleitung 26, die über den Umschalter 19 den Knoten mit dem Filter 20 und über den Filter 20 mit der Ausgangsklemme 37 verbindet. Die Spannungsmesseinrichtung 3 misst jetzt die unmittelbar am Messwiderstand 16 abfallende Spannung.

Der Messwiderstand 16 ist derart dimensioniert, dass die an der Body-Diode 24 des MOSFET 13 abfallende Spannung geringer ist, als die Flussspannung der Body-Diode 24 des MOSFETs 13.

Soll von der Messschaltung 1 eine von den Eingangsklemmen 11, 11' gelieferte Spannung gemessen werden, so wird von der Steuerschaltung 4 der Umschalter 19 umgeschaltet, sodass er den in der Figur 3 oben angeordneten Schaltkontakt mit dem gemeinsamen Kontakt des Umschalters 19 verbindet. Am Gate des MOSFET 13 liegt jetzt ein Signal S1 an, das den MOSFET 13 sperrt. Der Umschalter 19 hat jetzt den Filter 20 beziehungsweise die Ausgangsklemme 37 unmittelbar mit der Eingangsklemme 11 verbunden, sodass die nicht dargestellte Spannungsmesseinrichtung 3 die an den Eingangsklemmen 11, 11' anliegende Spannung misst.

Ein Kondensator 18 besitzt eine geringe Kapazität und ist zwischen den oberen Schaltkontakt beziehungsweise der Eingangsklemme 11 und der Eingangsklemme 11' geschaltet, um hochfrequente Wechselströme kurzzuschließen. Die Kapazität des Kondensators 18 ist derart gering, dass der am Messwiderstand 16 bei der Strommessung gemessene Messwert nicht verfälscht wird.

Bei dem in der Figur 4 dargestellten Ausführungsbeispiel ist zusätzlich ein weiterer Schalter 15 vorgesehen, mit dem wahlweise der Kondensator 18 beziehungsweise der obere Schaltkontakt des Umschalters mit der Ausgangsklemme 11 über die Verbindungsleitung 25 verbunden werden kann. Der Schalter 15 ist bevorzugt ebenfalls ein MOSFET. Das Schaltsignal S2 kann von der Steuerschaltung 4 bereitgestellt werden. Der Schalter 15 ist nur dann leitend, wenn der Umschalter 19 mit dem Schalter 15 verbunden ist, also wenn die an den Eingangsklemmen 11, 11' anliegende Spannung gemessen werden soll. Es ist eine Messwiderstandsanordnung vorgesehen, die aus zwei in Reihe geschalteten Messwiderständen 16, 17 besteht. Der vom Stromwandler 8 gelieferte Strom kann wahlweise nur durch einen Messwiderstand 16 oder gleichzeitig durch beide Messwiderstände 16, 17 hindurchfließen, wobei am Messpunkt 38 die Messspannung abgegriffen wird.

Die in der Figur 4 dargestellte Schaltung kann in verschiedener Weise mit einem Stromwandler 8 beschaltet werden. Um einen Strombereich bis beispielsweise maximal 1 A zu messen, ist die Eingangsklemme 11 mit der Verbindungsleitung 25 verbunden, die die Eingangsklemme 11 mit dem Schalter 13 verbindet. Wird der Schalter 13 leitend, so fließt der Strom durch zwei in Reihe geschaltete Messwiderstände 17, 16, welche wiederum in Reihe mit dem Schalter 13 geschaltet sind. Am Messpunkt 38 zwischen Schalter 13 und Messwiderstand 17 kann mit einer Verbindungsleitung 27 eine Messspannung abgegriffen werden, die über den unteren Schaltkontakt, der vom Umschalter 19 in Leitverbindung mit dem gemeinsamen Kontakt des Umschalters 19 gebracht ist, auch an der Ausgangsklemme 37 anliegt.

Soll hingegen ein Strombereich bis beispielsweise maximal 5 A gemessen werden, so wird die Eingangsklemme 11 in elektrisch leitenden Kontakt mit der Klemme 23 gebracht, sodass der von den Eingangsklemmen 23, 11' gelieferte Strom durch die Verbindungsleitung 28 nur durch den Messwiderstand 16 fließt. Am Messpunkt 38 wird dann bei sperrendem Schalter 13 die Spannung gemessen, die über den Messwiderstand 16 aufgrund des durch diesen fließenden Stroms abfällt und über den Messwiderstand 17 an den Messpunkt 38 weitergeleitet wird, wobei der Spannungsabfall über den Widerstand 17 vernachlässigbar gering ist. Am Messpunkt 38 wird dann bei sperrendem Schalter 13 die Spannung gemessen, die über den Messwiderstand 16 und 17 abfällt. Hierbei ist der Spannungsabfall über den Messwiderstand 17 vernachlässigbar, da der Strom vorrangig durch den Messwiderstand 16 fließt. Indem der untere Schaltkontakt mit dem gemeinsamen Kontakt des Umschalters 19 verbunden ist, kann die Spannung über die Eingangsklemmen 21, 21' von der Spannungsmesseinrichtung 3 gemessen werden.

Bei der in der Figur 5 dargestellten Schaltung wird eine Bereichsumschaltung durch zwei Anordnungen von jeweils einem Schalter 13, 14 und einem Messwiderstand 16, 17 verwirklicht. Die beiden Anordnungen sind parallel zwischen den Eingangsklemmen 11, 11' geschaltet. Jede Anordnung besitzt einen zwischen Schalter 13, 14 und Messwiderstand 16, 17 angeordneten Messpunkten 38, 40, an dem mittels einer Verbindungsleitung 26, 27 eine am Messwiderstand 16, 17 abfallende Messspannung abgegriffen werden kann. Hierzu wird jeweils nur eine der Verbindungsleitungen 26, 27 über den Umschalter 19 und den Filter 20 mit der Eingangsklemme 21 des Ausgangs 22 verbunden.

Auch bei diesem Ausführungsbeispiel werden die Schalter 13, 14 und der Umschalter 19 gemeinsam betätigt. Verbindet der Umschalter 19 den gemeinsamen Kontakt mit dem mit der Verbindungsleitung 27 verbundenen Schaltkontakt, ist der Schalter 14 leitend und der Schalter 13 sperrend. Ebenso ist ein weiterer Schalter 15 sperrend, der die Eingangsklemme 11 mit einem Kondensator 18 verbindet. Es wird die am Messwiderstand 17 abfallende Spannung gemessen. Verbindet hingegen der Umschalter 19 den gemeinsamen Kontakt mit dem mit der Verbindungsleitung 26 verbundenen Schaltkontakt, so ist der Schalter 13 leitend und die Schalter 14 und 15 sind sperrend. Es wird jetzt die am Messwiderstand 16 abfallende Spannung gemessen.

Auch hier sind die Messwiderstände 16, 17 derart dimensioniert, dass die an den Body-Dioden 24 der die Schalter 13, 14 bildenden MOSFET abfallenden Spannungen unter der Flussspannung der Body-Diode 24 der MOSFETs 13 und 14 liegt.

Die zur Strommessung eingesetzten Stromwandler 8 werden mit Hilfe der erfindungsgemäß konfigurierbaren Eingangsbeschaltung belastet. Hierbei wird jeweils mit einem N-Kanal MOSFET 13, 14 pro Stromwandlerart ein separater Belastungszweig geschaltet. Bei Ausführungsbeispielen der Erfindung kann jede der drei Phasen L1, L2, L3 mit einer Schaltung gemäß der Figuren 3 bis 5 zusammenwirken. Als Transformatoren ausgebildete Stromwandler 8 werden niederohmig belastet. Als beispielsweise Rogowski-Spule ausgebildete Stromwandler 8 werden hingegen hochohmig belastet. Hierzu ist in den Ausführungsbeispielen der Kondensator 18 vorgesehen, der eine ausreichend geringe Kapazität aufweist und der gemäß der Ausführungsbeispiele der Figuren 4 und 5 mittels eines separaten Schalters 15 mit der Eingangsklemme 11 verbunden wird. Dies erfolgt einhergehend mit einer elektrischen Leitverbindung der Ausgangsklemme 37 beziehungsweise der Eingangsklemme 21 mit der Eingangsklemme 11. Die MOSFETs sind derart ausgewählt, dass ihr Drain-Source-Widerstand im aktivierten Zustand ausreichend gering ist und gleichzeitig im deaktivierten Zustand ausreichend hoch ist. Für den Belastungszweig ist der Widerstand so gering, dass keine bemerkenswerte Erwärmung des MOSFETs aufgrund des durch diesen fließenden Stroms hervorgerufen wird. Bei der Spannungsmessung ist die Belastung so hochohmig, dass der spannungsführende Ausgang des eine Spannung liefernden Stromwandlers nicht belastet wird und somit keine bemerkenswerte Beeinflussung des zu messenden Ausgangssignals entsteht. Die erfindungsgemäßen Komponenten sind derart aufeinander abgestimmt, dass eine Messverfälschung minimiert wird. Dies geschieht insbesondere dadurch, dass die Größe der Messsignale kleiner ist, als die Flussspannungen der Body-Dioden der MOSFETs. Gleichzeitig wirken die Body-Dioden 24 als Schutzelemente, wenn Fehlkonfigurationen auftreten, und schützen nachgeschaltete Schaltungszweige. Weiterhin weist der verwendete MOSFET im jeweiligen Belastungszweig eine Body-Diode 24 auf, welche bei betragsmäßig zu hoher negativer Eingangsspannung leitend wird und für diesen Fall die betragsmäßig maximal negative Messspannung am Ausgang der Stromwandler begrenzt. Die Body-Diode 24 weist gleichzeitig eine ausreichend hohe Flussspannung auf, damit Gleich- und Wechselstromsignale und damit die zu erfassende maximale Messspannung am Ausgang der Stromwandler nicht beeinflusst wird. Überdies wird über eine Spannungsbegrenzungsschaltung 12 am Eingang des Strommesskanals die Ausgangsspannung der Stromwandler auf einen für die nachgelagerte Messschaltung vertretbaren Wert limitiert. Für die konfigurierbare Filterschaltung 20 werden elektronische Schalter verwendet, welche die Aufschaltung auf den aktuell verwendeten Belastungszweig realisieren. Zusätzlich weisen diese Schalter einen ausreichend geringen Widerstand im aktivierten Zustand auf, welcher über den gesamten Betriebstemperaturbereich keinen bemerkenswerten Einfluss auf das zu filternde Messsignal hat.

Der Messpunkt 39, mit dem die Ausgangsklemme 37 galvanisch leitend verbunden wird, wenn die an den Eingangsklemmen 11, 11' anliegende Spannung gemessen werden soll, ist entweder permanent mit der Eingangsklemme 11 elektrisch leitverbunden oder aber wahlweise mit einem Schalter 15 mit der Eingangsklemme 11 elektrisch leitverbindbar. In nicht dargestellten Ausführungsbeispielen, die Varianten der in den Figuren 3, 4, 5 dargestellten Ausführungsbeispiele sind, kann zu der Überspannungsschutzeinrichtung 12 eine antiparallel zur Body-Diode 24 geschaltete Diode eingefügt sein.

Die Kommunikationsschnittstelle 6 kann eine kabelgebundene Schnittstelle oder eine Funk-Schnittstelle sein (Modbus, USB, Can, I2C, SPI und dergleichen sind ebenfalls möglich). Wesentlich an der Kommunikationsschnittstelle 6 ist die Möglichkeit, auf die Messdaten zugreifen zu können. Über die Schnittstelle können Mess- und/ oder Berechnungswerte an eine übergeordnete Einheit, beispielsweise einen Datenspeicher 36 oder eine EDV-Einrichtung 35, übertragen werden. Über die Kommunikationsschnittstelle 6 kann aber auch eine Parametrisierung der Messschaltung beziehungsweise der Energiemessklemme vorgenommen werden.

Die Isolationseinrichtung 5 liefert eine galvanische Trennung. Die galvanische Trennung erfolgt ohne zusätzliches Oszillatorsignal über planare magnetische oder optische Isolationselemente.

Die Figur 6 zeigt eine Spannungsmessschaltung 2, mit der eine der in der Figur 1 dargestellten Spannungen zwischen den Leitern 9, 9', 9" gemessen werden kann. Auch hier ist eine Überspannungsschutzschaltung 12 zwischen den beiden Ausgangsklemmen des Spannungswandlers 7 vorgesehen. Es sind zwei Spannungsteilerschaltungen 30, 31; 32, 33 vorgesehen. Die Spannungsteilerschaltung 30, 31 wird von mindestens zwei Widerständen ausgebildet, von denen einer an einer Eingangsklemme 11 des Spannungswandlers 7 und ein anderer an Masse geschaltet ist. Am Knoten wird eine Spannung abgegriffen. Die Spannungsteilerschaltung 32, 33 ist dazu symmetrisch ausgebildet, jedoch optional. Auch hier wird am Knoten eine Spannung abgegriffen und ist der Widerstand 33 mit Masse verbunden. Es ist ein Filter 20 vorgesehen, mit dem hochfrequente Störsignale ausgefiltert werden. Wird die Spannungsteilerschaltung 32, 33 nicht verwendet, wird die Eingangsklemme 11' direkt gegen Masse geschaltet. Auf der Sekundärseite des Filters 20, an dessen Primärseite die beiden abgegriffenen Spannungen anliegen, ist der Messumformer 3 über den Ausgang 34 angeschlossen.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, wobei zwei, mehrere oder alle dieser Merkmalskombinationen auch kombiniert sein können, nämlich:

Eine Messschaltung, die gekennzeichnet ist durch einen Umschalter 19, mit dem eine der Ausgangsklemmen 37 des Ausgangsklemmenpaares 37, 37' in der Strommessstellung mit dem ersten Messpunkt 38 und in der Spannungsmessstellung mit einem zweiten Messpunkt 39 verbindbar ist.

Eine Messschaltung, die gekennzeichnet ist durch einen zweiten Schalter 14, der in der Strommessstellung einen zweiten Messwiderstand 17 zwischen die Eingangsklemmen 11, 11' derart schaltet, dass eine an einem dritten Messpunkt 40 des zweiten Messwiderstandes 17 anliegende stromabhängige Messspannung abgreifbar ist.

Eine Messschaltung, die dadurch gekennzeichnet ist, dass der Umschalter 19 die Ausgangsklemme 37 wahlweise mit dem ersten Messpunkt 38, dem zweiten Messpunkt 39 oder einem dritten Schalter 24, der in einem leitenden Zustand die Eingangsklemme 11 mit der Ausgangsklemme 37 verbindet, in eine Leitverbindung bringt und/ oder dass der Umschalter 19 die Ausgangsklemme 37 unmittelbar mit der Eingangsklemme 11 verbindet und/oder dass der dritte Schalter 24 im leitenden Zustand die beiden Eingangsklemmen 11, 11' mit einem Kondensator 18 verbindet, der auch zwischen den Ausgangsklemmen 37, 37' geschaltet ist.

Eine Messschaltung, die dadurch gekennzeichnet ist, dass zumindest einer der ersten, zweiten oder dritten Schalter 13, 14, 15 ein Halbleiter-Schaltelement, beispielsweise ein MOSFET ist.

Eine Messschaltung, die dadurch gekennzeichnet ist, dass der in Reihe mit dem jeweils als MOSFET ausgebildeten ersten oder zweiten Schalter 13, 14 geschaltete erste oder zweite Messwiderstand 16, 17 derart dimensioniert ist, dass die an dem mit dem jeweiligen Schalter in Reihe geschalteten MOSFET 13, 14 oder an einem mit einem anderen Messwiderstand 16, 17 in Reihe geschalteten MOSFET 13, 14 abfallende Spannung geringer ist, als die Flussspannung der Body-Diode 24 des MOSFET 13, 14.

Eine Messschaltung, die dadurch gekennzeichnet ist, dass zwischen den Ausgangsklemmen 37, 37' und Eingangsklemmen 21, 21' einer Spannungsmesseinrichtung 3, mit der die an den Ausgangsklemmen 37, 37' anliegende Spannung messbar ist, ein Filter 20 geschaltet ist.

Eine Messschaltung, die dadurch gekennzeichnet ist, dass zwei Messwiderstände 16, 17 in Reihe mit dem ersten Schalter 13 geschaltet sind und der erste Messpunkt 38 zwischen erstem Schalter 13 und den beiden Messwiderständen 16, 17 liegt, wobei eine Verbindungsleitung 28 mit dem Verbindungsknoten der beiden Messwiderstände 16, 17 wahlweise anstelle einer Verbindungsleitung 25 zum dritten Schalter 15 oder zum Umschalter 19 mit der Ausgangsklemme des Stromwandlers 8 verbindbar ist.

Eine Energiemessklemme, die dadurch gekennzeichnet ist, dass die Strommessschaltung 1 eine Messschaltung gemäß einem der Ansprüche 1 bis 7 ist.

Eine Energiemessklemme, die dadurch gekennzeichnet ist, dass die Spannungsmessschaltung 2 zumindest einen Spannungsteiler 30, 31 aufweist, an dem der Messumformer 3 eine Spannung abgreift und/ oder dass die Steuerschaltung 4 zumindest einen der ersten Schalter 13, zweiten Schalter 14 oder dritten Schalter 15 synchron mit dem Umschalter 19 schaltet.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen. Die Unteransprüche charakterisieren, auch ohne die Merkmale eines in Bezug genommenen Anspruchs, mit ihren Merkmalen eigenständige erfinderische Weiterbildungen des Standes der Technik, insbesondere um auf Basis dieser Ansprüche Teilanmeldungen vorzunehmen. Die in jedem Anspruch angegebene Erfindung kann zusätzlich ein oder mehrere der in der vorstehenden Beschreibung, insbesondere mit Bezugsziffern versehene und/ oder in der Bezugsziffernliste angegebene Merkmale aufweisen. Die Erfindung betrifft auch Gestaltungsformen, bei denen einzelne der in der vorstehenden Beschreibung genannten Merkmale nicht verwirklicht sind, insbesondere soweit sie erkennbar für den jeweiligen Verwendungszweck entbehrlich sind oder durch andere technisch gleichwirkende Mittel ersetzt werden können.

**Liste der Bezugszeichen**

| | | | |
|---|---|---|---|
| 1 | Strommessschaltung | 21' | Eingangsklemme |
| 2 | Spannungsmessschaltung | 22 | Ausgang |
| 3 | Messumformer, Spannungsmesseinrichtung | 23 | Klemme |
| | | 24 | Body-Diode |
| 4 | Mikrokontroller, Steuerschaltung | 25 | Verbindungsleitung |
| | | 26 | Verbindungsleitung |
| 5 | Isolationseinrichtung | 27 | Verbindungsleitung |
| 6 | Komm unikationsschnittstelle | 28 | Verbindungsleitung |
| 7 | Spannungswandler | 29 | Verbindungsleitung |
| 8 | Stromwandler | 30 | Widerstand, Spannungsteiler |
| 8' | Stromwandler | 31 | Widerstand, Spannungsteiler |
| 9 | Leiter, Phase | 32 | Widerstand, Spannungsteiler |
| 9' | Nullleiter | 33 | Widerstand, Spannungsteiler |
| 9" | Schutzleiter | 34 | Ausgang |
| 10 | Energiemessklemme | 35 | EDV-Einrichtung |
| 11 | Eingangsklemme | 36 | Datenspeicher |
| 11' | Eingangsklemme | 37 | Ausgangsklemme |
| 12 | Überspannungsschutzschaltung | 37' | Ausgangsklemme |
| | | 38 | Messpunkt |
| 13 | erster Schalter, MOSFET | 39 | Messpunkt |
| 14 | zweiter Schalter, MOSFET | 40 | Messpunkt |
| 15 | dritter Schalter, MOSFET | | |
| 16 | erster Messwiderstand | | |
| 17 | zweiter Messwiderstand | | |
| 18 | Kondensator | | |
| 19 | Umschalter | L1 | Phase |
| 20 | Filter | L2 | Phase |
| 21 | Eingangsklemme | L3 | Phase |
| N | Nullleiter | | |
| N9 | Nullleiter | | |
| N9' | Nullleiter | | |
| S1 | Signal | | |
| S2 | Signal | | |
| S3 | Signal | | |
| S4 | Signal | | |

## Patentansprüche

1. An einen Stromwandler (8) anschließbare Messschaltung zur Ermittlung der Größe eines durch einen Leiter (9) fließenden Stroms, mit einem Eingangsklemmenpaar (11, 11'), dass an den Stromwandler (8) anschließbar ist, mit einem ersten Schalter (13), der in einer Strommessstellung einen Messwiderstand (16, 17) zwischen die Eingangsklemmen (11, 11') schaltet und der in einer Spannungsmessstellung den Messwiderstand (16, 17) von zumindest einer der Eingangsklemmen (11, 11') trennt, und mit einem Ausgangsklemmenpaar (37, 37'), an dem wahlweise eine an dem Eingangsklemmenpaar (11, 11') anliegende spannungsabhängige Messspannung oder eine an einem ersten Messpunkt (38) des Messwiderstandes (16, 17) anliegende stromabhängige Messspannung abgreifbar ist, **gekennzeichnet durch** einen Umschalter (19), mit dem eine der Ausgangsklemmen (37) des Ausgangsklemmenpaares (37, 37') in der Strommessstellung mit dem ersten Messpunkt (38) und in der Spannungsmessstellung mit einem zweiten Messpunkt (39) verbindbar ist.

2. Messschaltung nach Anspruch 1, **gekennzeichnet durch** einen zweiten Schalter (14), der in der Strommessstellung einen zweiten Messwiderstand (17) zwischen die Eingangsklemmen (11, 11') derart schaltet, dass eine an einem dritten Messpunkt (40) des zweiten Messwiderstandes (17) anliegende stromabhängige Messspannung abgreifbar ist.

3. Messschaltung nach einem der vorhergehenden Ansprüche, **dadurch gekennzeichnet, dass** der Umschalter (19) die Ausgangsklemme (37) wahlweise mit dem ersten Messpunkt (38), dem zweiten Messpunkt (39) oder einem dritten Schalter (24), der in einem leitenden Zustand die Eingangsklemme (11) mit der Ausgangsklemme (37) verbindet, in eine Leitverbindung bringt.

4. Messschaltung nach einem der vorhergehenden Ansprüche, **dadurch gekennzeichnet, dass** der Umschalter (19) die Ausgangsklemme (37) unmittelbar mit der Eingangsklemme (11) verbindet.

5. Messschaltung nach einem der vorhergehenden Ansprüche, **dadurch gekennzeichnet, dass** der dritte Schalter (24) im leitenden Zustand die beiden Eingangsklemmen (11, 11') mit einem Kondensator (18) verbindet, der auch zwischen den Ausgangsklemmen (37, 37') geschaltet ist.

6. Messschaltung nach einem der vorhergehenden Ansprüche, **dadurch gekennzeichnet, dass** zumindest einer der ersten, zweiten oder dritten Schalter (13, 14, 15) ein Halbleiter-Schaltelement, beispielsweise ein MOSFET ist.

7. Messschaltung nach einem der vorhergehenden Ansprüche, **dadurch gekennzeichnet, dass** der in Reihe mit dem jeweils als MOSFET ausgebildeten ersten oder zweiten Schalter (13, 14) geschaltete erste oder zweite Messwiderstand (16, 17) derart dimensioniert ist, dass die an dem mit dem jeweiligen Schalter in Reihe geschalteten MOSFET (13, 14) oder an einem mit einem anderen Messwiderstand (16, 17) in Reihe geschalteten MOSFET (13, 14) abfallende Spannung geringer ist, als die Flussspannung der Body-Diode (24) des MOSFET (13, 14).

8. Messschaltung nach einem der vorhergehenden Ansprüche, **dadurch gekennzeichnet, dass** zwischen den Ausgangsklemmen (37, 37') und Eingangsklemmen (21, 21') einer Spannungsmesseinrichtung (3), mit der die an den Ausgangsklemmen (37, 37') anliegende Spannung messbar ist, ein Filter (20) geschaltet ist.

9. Messschaltung nach einem der vorhergehenden Ansprüche, **dadurch gekennzeichnet, dass** zwei Messwiderstände (16, 17) in Reihe mit dem ersten Schalter (13) geschaltet sind und der erste Messpunkt (38) zwischen erstem Schalter (13) und den beiden Messwiderständen (16, 17) liegt.

10. Messschaltung nach einem der vorhergehenden Ansprüche, **dadurch gekennzeichnet, dass** eine Verbindungsleitung (28) mit einem Verbindungsknoten der beiden Messwiderstände (16, 17) wahlweise anstelle mit einer Verbindungsleitung (25) zum dritten Schalter (15) oder zum Umschalter (19) mit der Ausgangsklemme des Stromwandlers (8) verbindbar ist.

11. Energiemessklemme mit einer an einen Spannungswandler (7) oder direkt an einen Leiter (9) und einen Nullleiter (9') anschließbaren Spannungsmessschaltung (2), einer an einem Stromwandler (8) anschließbaren Strommessschaltung (1), einem Messumformer (3) mit einer Spannungsmesseinrichtung zur Messung der von der Spannungsmessschaltung (2) und von der Strommessschaltung (1) gemessenen Spannung und deren Phasenlage zur Ermittlung von elektrischen Leistungsparametern, mit einer Steuerschaltung (4) und mit einer Kommunikationsschnittstelle (6), **dadurch gekennzeichnet, dass** die Strommessschaltung (1) eine Messschaltung gemäß einem der Ansprüche 1 bis 10 ist.

12. Energiemessklemme nach Anspruch 11, **dadurch gekennzeichnet, dass** die Spannungsmessschaltung (2) zumindest einen Spannungsteiler (30, 31) aufweist, an dem der Messumformer (3) eine Spannung abgreift.

13. Energiemessklemme nach Anspruch 11 oder 12, **dadurch gekennzeichnet, dass** die Steuerschaltung (4) zumindest einen der ersten Schalter (13), zweiten Schalter (14) oder dritten Schalter (15) synchron mit dem Umschalter (19) schaltet.

14. Vorrichtung oder Verfahren, **gekennzeichnet durch** eines oder mehrere der kennzeichnenden Merkmale eines der vorhergehenden Ansprüche.
